Europäisches Patentamt

European Patent Office

Office européen des brevets

(11) Publication number: **0 242 652 B1**

## EUROPEAN PATENT SPECIFICATION

(45) Date of publication of patent specification: **18.03.92**

(51) Int. Cl.5: **H01L 29/76**, H01L 29/10, G02F 1/015

(21) Application number: **87104812.0**

(22) Date of filing: **01.04.87**

(54) Electron tuned quantum well device.

(30) Priority: **22.04.86 US 854635**

(43) Date of publication of application:
**28.10.87 Bulletin 87/44**

(45) Publication of the grant of the patent:
**18.03.92 Bulletin 92/12**

(84) Designated Contracting States:
**DE FR GB IT**

(56) References cited:
**US-A- 4 550 330**

**PHYSICS LETTERS vol. 96A no 7, pages 365-367, 18 July 1983 Amsterdam, North Holland M. Buettiker et al " Josephson behaviorin small normal one dimensional rings"**

**IBM JOURNAL OF RESEARCH AND DEVELOPEMENT PAGES 223-231; July 1957 R. Landauer: "Spatial variation of currents and fields due to localized scatters in metallic conduction "**

**PATENT ABSTRACTS OF JAPAN VOL: 10 NO:**

363 E(461)(2420), 5th December 1986; & JPA 61159769.

(73) Proprietor: **International Business Machines Corporation**
**Old Orchard Road**
**Armonk, N.Y. 10504(US)**

(72) Inventor: **Fowler, Alan Bicksler**
**3511 Kamhi Drive**
**Yorktown Heights, N.J. 10598(US)**
Inventor: **Timp, Gregory Louis**
**15, Squankum-Yellow Brook Road**
**Farmingdale, N.J. 07727(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

## Description

This invention relates to semiconductor signal devices wherein the signal current is through carriers in a quantum well. Such devices require very little physical space and dissipate very small amounts of energy. This invention is in electrostatic control of current in the quantum well type of signal device.

One quantum well type of signal device structure described in U.S. Patent 4,550,330 employs an electrostatic field to control a traveling wave of carriers in the quantum well and the signal is developed by the relationship of the phase of the traveling wave with respect to a bifurcated conductor.

Another quantum well type signal device structure described in Physical Review Letters 52, No. 2, January 1984, p.129, employs a magnetic field to control carriers in the quantum well with the signal being sensed using a bifurcated conductor.

Still another quantum well type structure that uses an electrostatic field to produce interference effects in conductance is described in Appl. Phys. Lett. 48 (7), 17 Feb. 1986, p.487.

In accordance with the invention a reflected wave produced in an appendage to a conductor in a quantum well type device provides constructive or destructive interference to a traveling wave in the quantum well.

For clarity of explanation, the invention will be illustrated in terms of the control of a travelling wave of the carriers in the quantum well in a semiconductor heterojunction, where the appendage is a tuned stub on a conductor positioned on the surface over the quantum well and the reflected wave is modified or controlled by an electrostatic field. It will, however, be apparent to one skilled in the art in the light of the principles set forth that many substitutions, such as the use of a magnetic field, may be employed.

In accordance with the invention, the wave properties of electrons in a very narrow conductor in the vicinity of a quantum well will be such that, if the conductor is narrow enough, the electrons will be quantized both perpendicular to the surface by the surface field and parallel to the surface by the lithography of the line. This gives rise to quantum levels and produces two dimensional sub-bands which may be broken into one dimension sub-bands. For each sub-band, there will be a standing wave structure, which in a sense will correspond to different modes in a waveguide.

In the heterostructure illustration of the invention, the wavelength will not be unique to the mode but will be a function of the filling of the sub-band and of the Fermi level. Though there will be a different Fermi wavelength ($\lambda_F$) for each occupied sub-band, if the separation or splitting of the sub-bands is sufficient, then most of the conduction electrons will lie on a single sub-band which in turn will have some characteristic wavelength ($\lambda$) along the line. In effect, interference effects in this case are dominated by a single channel.

In accordance with the invention, the wave properties can be utilized in an appendage in a way that is similar to the properties of photons in a waveguide.

For further clarity of explanation, the invention will be described in terms of the heterojunction that produces the quantum well at the interface of a GaAs and $Ga_{1-x}Al_xAs$ semiconductor structure and the carriers being electrons, although again in the light of the principles being set forth, other materials, structural variations and carrier types will be apparent to one skilled in the art, for example, metal insulator semiconductor structures.

FIG. 1 is a schematic illustration of the electron tuned quantum well device of the invention.

FIG. 2 is an energy diagram correlated with the structure illustrating the quantum well.

FIG. 3 is a schematic illustration of a traveling electron wave in a quantum well type structure.

FIG. 4 is a schematic illustration of the effect of a reflected wave on the traveling wave.

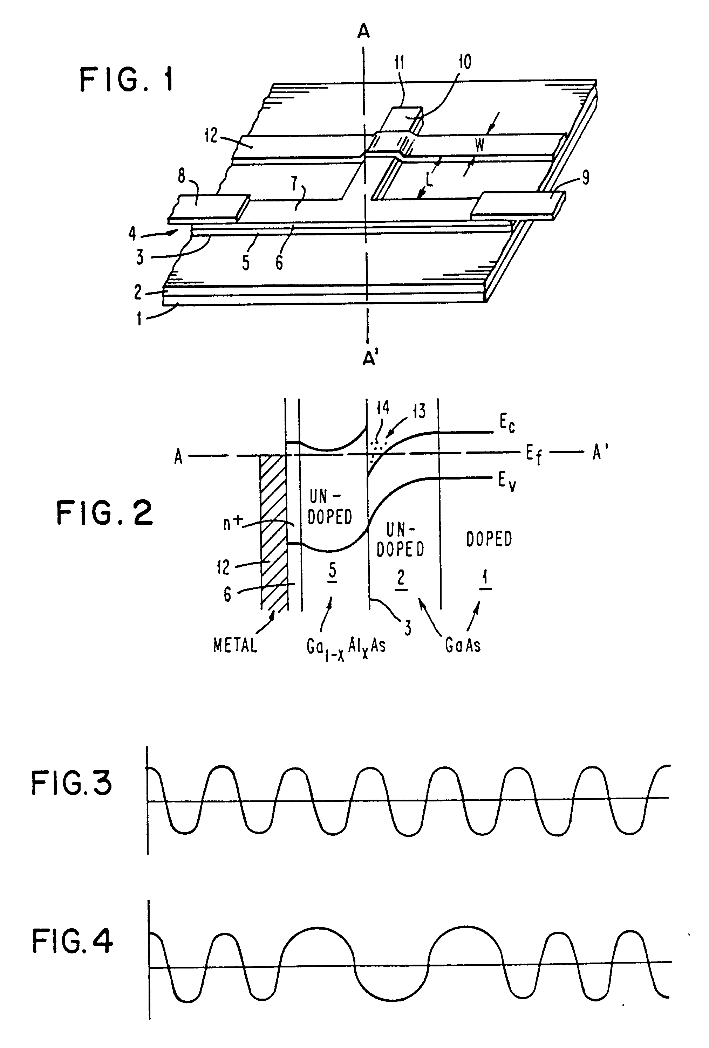

In FIG. 1 there is provided a schematic diagram of the elements of the invention in general functional relationship.

Referring to FIG. 1, a buffer layer 1 is provided of doped GaAs on a substrate, not shown. Epitaxial therewith there is a layer of doped GaAs 2. The layer 2 forms a heterojunction 3 with a region of a semiconductor 4 having a different energy band separation, of $Ga_{1-x}Al_xAs$. The $Ga_{1-x}Al_xAs$ in turn has an undoped layer 5 and a highly doped layer 6. Layers 5 and 6 are present only in the shape of the conductor path labeled 7. The heterojunction material properties are such that a quantum well or potential well exists on the side of the heterojunction interface away from the surface. The quantum well or potential well contains a carrier concentration sometimes referred to in the art as an electron gas. The conductor path 7 has an input contact 8 and an output contact 9.

In accordance with the invention, the conductor path 7 and the layers 5 and 6 are provided with an appendage or branch 10. The appendage or branch 10 has a specific length labelled L providing reflectance properties. The appendage has an end or terminus 11.

A gate 12 is provided over the appendage 10, having a control width labelled W.

By impressing a voltage signal relative to the gate contact 12, an electrical field perpendicular to the heterojunction 3 is applied.

In a structure, as shown in FIG. 1, a signal in conductor 7 between input 8 and output 9 will have quantized electrons in the quantum well. In the appendage 10 with the terminus 11, the electrons entering the appendage 10 are reflected off the terminus 11. The wavelengths of the electrons as they pass under the gate 12 will be modified and thus the current in conductor 7 will be modified. The modification takes place when an electric field is applied through gate 12.

This takes place between with a heterojunction, such as between 1 and 2 in FIG. 1, the electrons in the quantum well at the heterojunction interface will have a wave nature with essentially no loss of phase over relatively large distances since the inelastic mean free path of the electrons with respect to any scattering phenomenon can be longer than the critical dimensions of the structure involved. For the illustration, the inelastic mean free path is of the order of 10 micrometers in typical GaAs-GaAlAs heterostructures.

It should be noted, however, that a semiconductor structure employing the principles of the invention should have a size less than the inelastic mean free path for the scattering of electrons.

In the GaAs-Ga$_{1-x}$Al$_x$As device, electrons move in waves in the potential well adjacent to the heterojunction under the conductor 7 and where semiconductor material with a long electron inelastic mean free path is employed, the appendage 10 may have a length L of the order of the inelastic mean free path length. Under these conditions, the electric field applied by a signal on element 12 over a width W will change the electron wave length over a portion of the appendage which will in turn by reflection produce constructive or destructive interference in a signal in standing wave under the conductor path. The wavelength in the appendage is modified both before and after reflection from the terminus 11 so that the total length of the modification is 2W.

Referring next to FIG. 2, there is shown an energy diagram of the structure employing the principles of the invention taken along the line A-A' of FIG. 1. In the illustration of FIG. 2 the energy bands of the structure are shown for the regions identified by the reference numerals in FIG. 1.

The metal electrode is gate 12. The Ga$_{1-x}$Al$_x$As region 4 has a modulation doped n+ high conductivity layer 6 and an undoped layer 5 adjacent the heterojunction 3. The undoped GaAs layer 2 at the heterojunction 3 is in turn separated from a substrate that is not shown by a buffer layer of doped GaAs.

The energy band structure at the heterojunction 3 between semiconductor materials with different band gaps, that is, between the undoped Ga$_{1-x}$Al$_x$As layer 5 and the undoped GaAs layer 2, is such that the conduction band discontinuity produces the quantum well or potential well labelled element 13 in which there is a carrier or electron concentration called an electron gas labelled element 14.

In accordance with the invention, the magnitude of the electron gas and the performance of the wave behavior of the gas can be controlled by a signal applied to an appendage. The signal operates to change the Fermi level with respect to the potential well.

In FIG. 3, there is a schematic illustration of the wave. When an electric field is applied in the appendage 10, a reflected wave occurs that results in the localized distortion of the wave in FIG. 3 as is illustrated for destructive interference in FIG. 4.

For constructive interference, the wave emerging from the appendage 10 must be in phase with the wave approaching the appendage 10. This means that there can be no phase shift within the appendage. The interference that produces the distortion illustrated in FIG. 4 arises from the interference of the electron wave that continues along under the conductor 7 and that which proceeds up the appendage under 10 and returns to the wave under the conductor 7.

The general condition for constructive interference is as set forth in Equation 1.

Eq. 1     $2W (1/\lambda_0 - 1/\lambda_1) = \pm n$

and for destructive interference is as set forth in Equation 2.

Eq. 2     $2W (1/\lambda_0 - 1/\lambda_1) = \pm n + 1/2$

where
    W    is the length of the appendage under the gate,
    $\lambda_0$    is the Fermi wavelength in the channel and the appendage except under the gate,
    $\lambda_1$    is the wavelength under the gate 12 and
    n    is an integer
Thus, where
    W were to be 100 nm, and
    $\lambda_0$ were to be 28 nm,

then for destructive interference, $\lambda_1$ would be 26.2 nm or 30.5 nm. Destructive interference corresponds to a minimum current from 8 to 9 whereas constructive interference would correspond to a maximum.

In the structure of the invention, referring to FIG. 1, the region 2 would be undoped GaAs. The region 1 would be GaAs doped with Si to $10^{17}$ atoms per cubic centimeter. The layers 5 and 6 would be $Ga_{0.35}Al_{0.65}As$ doped in layer 6 with Si to $10^{17}$ atoms per centimeter cubed. Layer 5 would be undoped. The typical thickness for layer 5 would be 30 nm and for layer 6 would be 10 nm. The length L would be 200 nm and the width W would be 100 nm provide an assumption for calculation simplicity that L is the equivalent of 2W.

The Fermi level of energy of the electrons would be given by Equation 3.

$$Eq.\ 3 \qquad E_F = \frac{\hbar^2 k_F^2}{2m} = \frac{\hbar^2 (2\pi)^2}{2m\ \lambda_F^2}$$

where

$k_F$ and $\lambda_F$     are the wave vectors and wavelengths at the Fermi surface,

m     is the electron effective mass, and

$\hbar$     is Planck's constant divided by $2\pi$.

In an illustrative example, assume that the carrier concentration, $N_S$, in the quantum or potential well under conductor 7 is $8 \times 10^{11} cm^{-2}$, and that L is as assumed $= 200$ nm, then Equation 4 is employed to determine the $\lambda_0$ wavelength.

$$Eq.\ 4 \qquad \lambda_0 = \frac{25.0}{\cancel{200}} \left(\frac{10^{12}}{N_S}\right)^{1/2} = 28\ nm$$

To produce destructive interference the wavelength $\gamma_1$ which is under the gate 12, is changed by converting, using Eq. 1, to

$$Eq.\ 5 \qquad \lambda_1 = \frac{L}{\frac{L}{\lambda_0} \pm 1/2}$$

where the + corresponds to the two destructive interference conditions adjacent to the constructive peak. Under these conditions they $\lambda_1 = 26.2$ nm or 30.5 nm for the + or - sign, respectively.

The new values of $N_S$ under the gate 12 can be calculated from Eq. 4 and would be $9.1 \times 10^{11} cm^{-2}$ or $6.7 \times 10^{11} cm^{-2}$, respectively. Thus an increase of $N_S$ of $1.1 \times 10^{11} cm^{-2}$ or a decrease of $1.3 \times 10^{11} cm^{-2}$ can cause the device to change from constructive to destructive interference.

Assuming the thickness of the $Ga_{1-x}Al_xAs$ element 5 to be 40 nm then a voltage, $V_g$, of $+0.064$ V or $-0.075$ V, respectively, would change the interference condition to produce respectively constructive or destructive interference.

The gain of the device is dependent on the degree to which perfect interference is achieved. If the interference were perfect, the transmission, T, would be unity for constructive and zero for destructive interference. Any scattering would make both tend toward 0.5.

As an illustration, assuming T were to be $= 0.9$ for constructive and 0.1 for destructive interference, which is less than perfect interference, then the resistance, R, of the device can be determined using the Landauer formula described in the IBM Journal of Research and Development , July 1957, page 223, as set forth in Equation 6, or some modification thereof taking account of multiple channels.

4

$$\text{Eq. 6} \qquad R = \frac{\pi \hbar}{e^2} \frac{(1-T)}{T}$$

For constructive or destructive interference R would respectively be $1.4 \times 10^3$ or $1.1 \times 10^5$ ohms. If a drain voltage, $V_D$, were applied between ends 8 and 9 of conductor 7 in FIG. 1, then the current, $I_D$, would be $V_D/R$.

Where $V_D = 0.1V$, and, $R = 1.4 \times 10^3$ or $R = 1.1 \times 10^5$ the current would be $7 \times 10^{-5}$ A or $9 \times 10^{-7}$ A for a change of gate voltage, $V_g$, of about 0.07V. This represents a transconductance of about 1 millisiemens.

Greater or less gain would be achieved by changing L, by changing W, by changing the $Ga_{1-x}Al_xAs$ thickness, by changing T, or by changing $V_D$.

It should be noted however that the values illustrated are only approximate since Equation 6 is designed around a one dimensional situation but the analysis is sufficient to make the principles clear.

The lower the temperature, the easier to get a long inelastic mean free path.

Where the shift of phase is $2\pi$ radians, n changes by 1 in Equation 1, the conductance goes through a maximum and a minimum, and such a condition will provide the basis for a frequency multiplier.

In the light of the above principles of providing carriers in a potential well at a heterointerface under a conductor and then changing the wave behavior of the carriers by a reflected wave altered by a localized electric field, it will be apparent to one skilled in the art that many substitutions and changes to the structure may be made. As examples, it will be apparent that multiple gates in separate paths for logic may be used and the device may be used for frequency multiplication.

## Claims

1. Signal translating device comprising in combination
   a semiconductor crystal having a region of a first band gap semiconductor epitaxially joined and forming a heterojunction with a second semiconductor having a second smaller band gap,
   a conducting path (7) essentially coplanar with said heterojunction, said conducting path having a branch (10) at a location along the length thereof, said branch having an end or terminus (11) which is not connected to said path (7), the length of said branch being less than the inelastic mean free path of electrons in said second semiconductor material;
   and means (12) for impressing a localized electric field on said heterojunction through a portion of said branch.

2. Device of claim 1 wherein said first region is $Ga_{1-x}Al_xAs$ and said second region is GaAs.

3. Device of claim 2 wherein said $Ga_{1-x}Al_xAs$ region has the shape of said conducting path and is made up of a highly doped layer on an undoped layer, said undoped layer forming the heterojunction with said GaAs region.

4. Signal translating device of claim 2 or 3 where said GaAs is undoped and is separated from a substrate by a buffer layer of GaAs doped with Si to $10^{17}$ atoms/cm$^3$, and the $Ga_{1-x}Al_xAs$ is undoped adjacent said heterojunction and has a region at the surface of $Ga_{0.35}Al_{0.65}As$ doped with Si to $10^{17}$ atoms/cm$^3$.

5. Signal translating device of any one of the preceding claims where the length (L) of said branch from said conducting path to said portion for impressing a localized electric field is 200 nm and said portion of said branch for impressing said localized electric field has a width (W) of 100 nm.

## Revendications

1. Dispositif de translation de signal comprenant en combinaison :
   un semi-conducteur cristallin comportant une région d'un semi-conducteur d'une première largeur de bande interdite relié épitaxialement et formant une hétérojonction avec un second semi-conducteur ayant une seconde largeur de bande interdite plus petite,
   un trajet conducteur (7) essentiellement coplanaire avec ladite hétérojonction, ledit trajet conducteur ayant une branche (10) à un emplacement le long de sa longueur, ladite branche ayant une extrémité ou fin (11) qui n'est pas relié audit trajet (7), la longueur de ladite branche étant inférieure au parcours libre moyen inélastique des électrons dans ledit second matériau semi-conducteur ;

et un moyen (12) pour appliquer un champ électrique localisé sur ladite hétérojonction par l'intermédiaire d'une partie de ladite branche.

2. Dispositif selon la revendication 1, dans lequel ladite première région est $Ga_{1-x}Al_xAs$ et ladite seconde région est GaAs.

3. Dispositif selon la revendication 2, dans lequel ladite région de $Ga_{1-x}Al_xAs$ a la forme dudit trajet conducteur et est constituée d'une couche hautement dopée sur une couche non dopée, ladite couche non dopée formant l'hétérojonction avec ladite région de GaAs.

4. Dispositif de translation de signal selon la revendication 2 ou 3, dans lequel ledit GaAs est non dopé et est séparé d'un substrat par une couche intermédiaire de GaAs dopée avec Si à $10^{17}$ atomes/cm$^3$, et la couche de $Ga_{1-x}Al_xAs$ est non dopée adjacente à ladite hétérojonction et comporte une région au niveau de la surface de $Ga_{0,35}Al_{0,65}As$ dopée avec Si à $10^{17}$ atomes/cm$^3$.

5. Dispositif de translation de signal selon l'une quelconque des revendications précédentes, dans lequel la longueur (L) de ladite branche depuis ledit trajet de conducteur vers ladite partie pour appliquer un champ électrique localisé est de 200 nm et ladite partie de ladite branche pour appliquer ledit champ électrique localisé est d'une largeur (W) de 100 nm.

**Patentansprüche**

1. Signalübertragungseinheit bestehend aus folgenden Komponenten
einem Halbleiterkristall, welcher eine Halbleiterregion mit einer ersten Bandlücke aufweist, die epitaktisch verbunden ist und eine Heterojunction mit einer zweiten Halbleiterregion, die eine kleinere Bandlücke aufweist, bildet
einem Leitungspfad (7) der im wesentlichen koplanar mit der Heterojunction verläuft, wobei der Leitungspfad eine Abzweigung (10) im Längenbereich der Heterojunction aufweist und die Abzweigung ein Ende oder einen Abschluß (11) hat, welches nicht mit dem Leitungspfad (7) verbunden ist, wobei die Länge der Abzweigung kürzer ist als die unelastische freie Weglänge der Elektronen in der zweiten Halbleiterregion;
und Mittel (12) zur Erzeugung eines lokalen elektrischen Feldes in der Heterojunction durch einen Teil der Abzweigung.

2. Signalübertragungseinheit nach Anspruch 1, wobei die erste Region aus $Ga_{1-x}Al_xAs$ und die zweite Region aus GaAs besteht.

3. Signalübertragungseinheit nach Anspruch 2, wobei die $Ga_{1-x}Al_xAs$-Region den Umriß des Leitungspfads aufweist und aus einer hochdotierten Schicht auf einer undotierten Schicht besteht, wobei die undotierte Schicht die Heterojunction mit der GaAs-Region bildet.

4. Signalübertragungseinheit nach Anspruch 2 oder 3, wobei das GaAs undotiert ist und vom Substrat durch eine Puffer-Schicht aus GaAs dotiert mit $10^{17}$ Atomen/cm$^3$ Si getrennt ist und wobei das $Ga_{1-x}Al_xAs$ angrenzend an die Heterojunction undotiert ist und an der Oberfläche eine mit $10^{17}$ Atomen/cm$^3$ dotierte Region aus $Ga_{0.35}Al_{0.65}As$ aufweist.

5. Signalübertragungseinheit nach einem der vorangegangenen Ansprüche, wobei die Länge (L) der Abzweigung von dem Leitungspfad (7) bis zu dem Teil, der zur Erzeugung eines elektrischen Feldes dient, 200 nm beträgt und der Teil der Abzweigung, der zur Erzeugung des lokalen elektrischen Feldes dient, eine Breite (W) von 100 nm aufweist.

FIG. 1

A

11  10

12

W

8

7

L

9

4

3

5  6

2

1

A'

FIG. 2

14  13

$E_c$

A ———————————————————— $E_f$ ———— A'

$E_v$

n+

UN-
DOPED

UN-
DOPED

DOPED

12

6

5

2

1

METAL

3

$Ga_{1-x}Al_xAs$

GaAs

FIG. 3

FIG. 4